(19) **Europäisches Patentamt**
**European Patent Office**
**Office européen des brevets**

(11) **EP 4 361 659 A1**

(12) **EUROPEAN PATENT APPLICATION**

(43) Date of publication:
**01.05.2024 Bulletin 2024/18**

(21) Application number: **22203550.3**

(22) Date of filing: **25.10.2022**

(51) International Patent Classification (IPC):
**G01R 33/28** (2006.01)     **G01R 33/56** (2006.01)
**G01R 33/563** (2006.01)

(52) Cooperative Patent Classification (CPC):
**G01R 33/283; G01R 33/5608; G01R 33/56325;**
G01R 33/4835

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Koninklijke Philips N.V.
5656 AG Eindhoven (NL)**

(72) Inventors:
• **MEINEKE, Jan Jakob
  Eindhoven (NL)**
• **NIELSEN, Tim
  Eindhoven (NL)**

(74) Representative: **Philips Intellectual Property &
Standards
High Tech Campus 52
5656 AG Eindhoven (NL)**

(54) **FUSION OF MULTI-ORIENTATION 2D STACKS FOR CARDIAC MAGNETIC RESONANCE IMAGING**

(57)     Disclosed herein is a method comprising: controlling a magnetic resonance imaging system to acquire k-space data from a thoracic region of a subject in stacks of slices, each stack $s$ having a respective orientation, wherein the k-space data is acquired in a set of frames per slice, each frame $f$ having k-space data $y_{s,f}$ that is aquired during an acquisition time $t_f$, each frame $y_{s,t}$ comprising k-space data $y_{s,f,p}$ of each cardiac phase $p$ that is covered by the acquisition time $t_f$; and processing the acquired data cardiac phase-wise for determining per cardiac phase $p$ a three-dimensional, 3D, cardiac image that is motion corrected, the determination being performed by minimizing an error between image data representing $x_{s,f,p}$ the k-space data $y_{s,f,p}$ of a current cardiac phase $p$ and a corresponding prediction $\hat{x}_{s,f,p}$ that is obtained from an estimate $X_p$ of a 3D cardiac image.

Acquiring k-space data from a thoracic region of a subject in stacks of slices, wherein the k-space data is acquired in a set of frames per slice, each frame $y_{s,f}$ comprising k-space data $y_{s,f,p}$ of each cardiac phase $p$ that is covered by the acquisition time $t_f$

201

Processing the acquired data cardiac phase-wise for determining per cardiac phase $p$ a 3D cardiac image that is motion corrected, the determining being performed by minimizing an error between image data $x_{s,f,p}$ representing the k-space data $y_{s,f,p}$ of a current cardiac phase $p$ and a corresponding prediction $\hat{x}_{s,f,p}$ that is obtained from an estimate $X_p$ of a 3D cardiac image

203

Fig. 2

**Description**

FIELD OF THE INVENTION

The invention relates to magnetic resonance imaging, in particular to cardiac magnetic resonance imaging.

BACKGROUND OF THE INVENTION

Various tomographic medical imaging techniques such as Magnetic Resonance Imaging (MRI), Computed Tomography, Positron Emission Tomography, and Single Photon Emission Tomography enable detailed visualization of anatomical structures of a subject. A common feature of all of these imaging modalities is that it takes a significant amount of time to acquire the medical imaging data necessary to reconstruct a medical image. During the acquisition of the medical imaging data the subject may move voluntarily or involuntarily resulting in image corruption or artifacts. This is particularly true for cardiac imaging where the subject's heart is beating. The subject may also breath during the cardiac imaging also.

SUMMARY OF THE INVENTION

The invention provides for a medical system, a computer program, and a method in the independent claims. Embodiments are given in the dependent claims.
Today's planning procedures for cardiac imaging may be complicated which makes it unsuitable for non-expert operators. With these planning procedures using breath-hold scans, the patient may not be comfortable. In addition, there is a need for more information than the 2D cine-scans in standard views. Embodiments may provide a means of solving this. 2D data is acquired continuously in different orientations and locations covering the heart. The total number of slices, orientations and locations may be chosen automatically. The data of all slices may be fused into a single volume with isotropic resolution and three spatial dimensions and one temporal dimension. The resulting volume may be manually reformatted as desired, e.g., by the radiologist, during reading and/or automatically processed to yield standard cardiac views, e.g., short-axis or four chamber views.
In one aspect the invention provides for a medical system that comprises a memory storing machine executable instructions, and a computational system, wherein execution of the machine executable instructions causes the computational system to: control a magnetic resonance imaging system to acquire k-space data from a thoracic region of a subject in stacks of slices, each stack s having a respective orientation, wherein the k-space data is acquired in a set of frames per slice, each frame $f$ having k-space data $y_{s,f}$ that is aquired during an acquisition time $t_f$, each frame $y_{s,t}$ comprising k-space data $y_{s,f,p}$ of each cardiac phase $p$ that is covered by the acquisition time $t_f$; and process the acquired data cardiac phase-wise for determining per cardiac phase $p$ a three-dimensional, 3D, cardiac image that is motion corrected, the determining being performed by minimizing an error between image data $x_{s,f,p}$ representing the k-space data $y_{s,f,p}$ of a current cardiac phase p and a corresponding prediction $\hat{x}_{s,f,p}$ that is obtained from an estimate $X_p$ of a 3D cardiac image. The thoracic region may be considered to be a part of the chest of the subject that contains the subject's heart. The thoracic region of the subject contains the subject's heart.
The following notation may be used for simplification of the description. Assuming, for example, that $n$ stacks 1, 2, ..., $n$ have been or being acquired, where $n$ is an integer number higher than one, $n > 1$. The orientations of the stacks may be referred to as $O_1$, $O_2$...$O_n$ respectively. The number of frames may be $N$, that is $f$ varies between 1 and $N$. The number of cardiac phases per frame $f$ may be $M$, that is p varies between 1 and $M$.
In one example, the image data $x_{s,f,p}$ representing the k-space data $y_{s,f,p}$ may be the k-space data, that is $x_{s,f,p}$ = $y_{s,f,p}$ and $\hat{x}_{s,f,p} = \hat{y}_{s,f,p}$. Alternatively, the image data $x_{s,f,p}$ may be a reconstructed image of the k-space data $y_{s,f,p}$.
The 3D image $X_p$ for each cardiac phase p may be determined by solving an inverse problem, where $X_p$ is an unknown parameter of the inverse problem. The inverse problem may enable to discover the 3D image $X_p$ from its related measurements $x_{s,f,p}$ which are performed by the MRI system. For that, a measurement model may be defined to reflect the relationship between the 3D image $X_p$ and the measurements $x_{s,f,p}$. The relationship may, for example, be linear, e.g., $x_{s,f,p} = WX_p = \hat{x}_{s,f,p}$. where W may be measurement matrix. The inverse problem may be solved by using an optimization algorithm such as a convex optimization algorithm. The optimization algorithm may find an optimal 3D image $X_p$ that minimizes the error between the measurement $x_{s,f,p}$ and the prediction $\hat{x}_{s,f,p}$. The 3D images $X_1$, $X_2$....$X_M$, that solve the inverse problem of each cardiac phase, may provide the overall image volume $X = \{X_p\}_{p=1,...,M}$ for a current frame $f$. This provides the 3D+t image volume, with three spatial dimensions and a fourth temporal dimension defined by the cardiac phases.
The present subject matter may enable to obtain a 3D+time dataset, wherein the actual acquisitions are performed using 2D MRI e.g., in form of stacks of slices, resolved in time to capture motions such as cardiac motion, respiration motion etc. The MRI system may be configured to acquire the data from the thoracic region (e.g., especially from the heart of the subject) using a free-running cardiac magnetic resonance imaging protocol. The free-running cardiac magnetic resonance imaging protocol as used herein may encompass a magnetic resonance imaging protocol. It may also encompass a magnetic resonance imaging protocol that is configured for imaging the heart or a cardiac region. The term 'free-running' in free-running cardiac magnetic resonance imaging protocol indicates that the acquisition of the k-space data is continual or done on a repeated basis for enabling free-breathing scans.

In one example, the stacks to be acquired may be defined automatically e.g., by the computational system. The definition of the stack may comprise a determination of the orientation of the stack, the number of slices in the stack and other properties of the stacks. For example, each stack of the n stacks may comprise parallel slices. Each stack may consist of a number of slices within a predefined range. The range may, for example, be 1 to 40 slices but it is not limited to that range as the skilled person in the art can use different ranges that enable to reconstruct the 3D+time image volumes according to the present subject matter. The resolution of the slices may, for example, be smaller than or equal to a predefined minimum resolution e.g., the minimum slice resolution may be $1\times1$ mm in plane. The slice thickness may be smaller than a predefined maximum thickness. The maximum thickness may, for example, be 3 mm. The MRI system may acquire data in stacks of slices, e.g., as defined above, using the free-running cardiac magnetic resonance imaging protocol. Each stack may be acquired over a period of time e.g., of around 20 seconds. The acquisition time $t_f$ of each frame may be smaller than a maximum frame time e.g., the acquisition time $t_f$ may be equal to 50 milliseconds (ms). This may particularly be advantageous because the heart is in constant motion. The short acquisition time may effectively freeze respiratory motion and resolve cardiac phases and may thus avoid motion blurring artifacts. The slices of each stack may, for example, be acquired in an interleaved pattern e.g., alternating odd-even. One slice may be acquired at a time.

The present subject matter may be advantageous as it may eliminate complicated planning procedures, which makes it suitable for non-expert operators. At the same time, it may enable the high-contrast between blood and myocardium by using standard 2D sequences. Patient comfort and eligibility of patients for scanning may be improved by using free-breathing acquisition. Scan efficiency may be increased by replacing the planning time by diagnostic scanning time and by using free-breathing instead of breath-hold scans. The present subject may provide a 3D + time image of the heart and thus more information than the 2D cine-scans in standard views.

According to one embodiment, the execution of the machine executable instructions causes the computational system to perform the processing concurrently with the acquisition of the k-space data. This may be advantageous as it may provide real-time access to the 3D images which may be used to improve the subsequent acquisition of the data. For example, the 3D image data of the heart may enable a real-time and static visualization of external cardiac anatomy. Alternatively, the processing step may be performed offline after the k-space has been acquired. This may be advantageous in particular if the k-space data is acquired by an MRI system that is remotely connected to the computational system. This may further be advantageous if the acquired data is provided by multiple MRI systems that acquire data from similar subjects.

According to one embodiment, the orientations of the different stacks are different. That is, each pair of distinct orientations ($O_i$, $O_j$) are different, i.e., $O_i \neq O_j$ if $i \neq j$. Alternatively, groups of stacks may be defined such that each group of stacks may have a distinct and same orientation. The orientation of the stack may be a transverse orientation, coronal orientation, sagittal orientation or oblique orientation. The stacks in each group of stacks may or may not be consecutively acquired stacks. The n stacks are acquired consecutively, wherein the execution of the machine executable instructions causes the computational system to: determine an orientation $O_s$ for a current stack s of slices using at least one of: acquired data of the previous stacks e.g., 1...s - 1, heart rate and respiration state of the subject. The acquisition settings of the current stack may additionally be determined using at least one of: acquired data of the previous stacks e.g., 1...s - 1, heart rate and respiration state of the subject.

For example, the orientation of the current stack s may be determined to be different from the orientations of the previous stacks. In one example, the planning of a subsequent stack orientation may be performed based on the respiratory motion of the subject. This may particularly be advantageous as the respiratory motion may be semi-periodic, and follows a predictable series of motion states.

According to one embodiment, the execution of the machine executable instructions causes the computational system to: during acquisition of a current stack s of the slices, predict an orientation of a subsequent stack of the slices using a policy that is optimized using a reinforcement learning algorithm. The reinforcement learning algorithm may be a deep reinforcement learning algorithm. This embodiment may enable an accurate and automatic determination of the orientation that may enable to obtain accurate 3D images. The acquisition settings of the current stack may additionally be determined using the optimized policy. Alternatively, the orientation of the subsequent stack may be selected based on a fixed policy (e.g., random).

A set of parameters of MRI acquisition may be used to define the environment for the reinforcement learning algorithm. The set of parameters may, for example, comprise orientations of the previous stacks, heart rate and respiration state of the subject. Based on the set of parameters, an action may be taken to change the state of the MRI system. The state may, for example, be the orientation of the stack to be acquired by the MRI system. The training of the reinforcement learning algorithm may result in an optimized policy that defines an action to change the state of the MRI system with a maximum reward based on a current set of parameters.

According to one embodiment, the obtaining of the prediction $\hat{x}_{s,f,p}$ comprises: $\hat{x}_{s,f,p} = WX_p$ where $W$ relates spatial locations in the 3D cardiac image $X_p$ and the image data $x_{s,f,p}$ taking into account a motion transformation due to a cardiac motion and/or respiratory motion of the subject. The motion transformation may, for example, be a deformation transformation. This embodiment may enable to correct for motion. This may further improve the provided 3D images according to the present subject matter.

The matrix $W$ may be the geometric transformation. The matrix $W$ may have size $Nx \times Nx$, where $Nx$ may be the number of pixels in the image $x_{s,f,p}$. The matrix $W$ may be determined individually for each stack of the stacks. This may be advantageous as the geometry may depend on the stack orientation. Each row of the matrix $W$ may comprise coefficients that relate the spatial locations of the 3D image $X_p$ and the frame taking into account the movement defined by a spatial transformation. The spatial transformation may be determined using the spatial and temporal positions of the heart in each acquired frame. The motion transformations may be restricted by assuming a dependence only on the respiratory and cardiac motion state. The motion transformations may, for example, further take into account a bulk motion e.g., caused by a global shift of the subject. The spatial transformation may comprise a first transformation followed by a second transformation. The first transformation may be a transformation between the frame $f$ and the corresponding stack s. The first transformation may be performed by choosing one reference coordinate system. The reference coordinate system may be defined using any one of the stacks 1 to $n$. The first transformation may be performed from a local coordinate system of the slice of the current frame to the reference coordinate system. The second transformation may be a transformation between the stack s and the 3D image $X_p$. The second transformation may be performed from the reference coordinate system to the coordinate system of the 3D image $X_p$. The matrix $W$ may further take into account the spatial blurring and down-sampling. In one example, saturation artifacts from previous excitations can be tracked in subsequent images to enable quantification of motion parameters.

According to one embodiment, in case the image data $x_{s,f,p}$ is the k-space data $y_{s,f,p}$ (that is, $x_{s,f,p} = y_{s,f,p}$ and $\hat{x}_{s,f,p} = \hat{y}_{s,f,p}$) the obtaining of the prediction $\hat{y}_{s,f,p}$ comprises: $\hat{y}_{s,f,p} = E_{s,f,p}R_sM_fX_p$ where $M_f$ is a motion transformation operator that maps a reference motion state to a motion state for current frame $f$, $R_s$ is a resampling operator which accounts for the transformation from the 3D cardiac image $X_p$ to a current slice of the current frame $f$, $E_{s,f,p}$ is an encoding matrix. The motion transformation operator $M_f$ is defined for each frame $f$ separately. The matrix motion transformation operator $M_f$ may enable to take into account a deformation of the heart, during respiration, which is non-rigid. The resampling matrix $R_s$ is defined for each stack and accounts for the transformation from the 3D isotropic volume to the current measured slice. The encoding matrix $E_{s,f,p}$ includes a Fourier transform and coil sensitivity maps. This embodiment may enable a process of fusing data from multiple 2D slices into a single 3D volume.

According to one embodiment, in case the image data $x_{s,f,p}$ is a reconstructed image of the k-space data $y_{s,f,p}$, the obtaining of the prediction $\hat{x}_{s,f,p}$ comprises: $\hat{x}_{s,f,p} = R_sM_fX_p$ where $M_f$ is a motion transformation operator that maps a reference motion state to a motion state for current frame $f$, $R_s$ is a resampling operator which accounts for the transformation from the 3D cardiac image $X_p$ to a current slice of the current frame $f$.

According to one embodiment, the motion transformation is performed for a predefined region of interest (ROI) of the heart of the subject. This embodiment may improve accuracy and computation time. The region of interest may, for example, cover the heart, great vessels and arterial arches in each slice. The region of interest may have a relatively large volume in comparison to the volume of the heart. This may have the benefit that, for example, the subject could be aligned using an alignment device such as a projected light image or a laser to identify the rough location of a subject's heart and then the subject can be moved into the magnet and the procedure can start without the use of a scout image. This may reduce the burden on the operator in terms of training to perform the cardiac imaging.

According to one embodiment, the error between the k-space data $y_{s,f,p}$ and the prediction $\hat{y}_{s,f,p}$ is defined as

follows: $\left\| y_{s,t,p} - \hat{y}_{s,f,p} \right\|_2^2$ , where $\|.\|_2$ refers to the L2 norm. The optimization algorithm may solve this objective function: $\min_{X_p} \left\| y_{s,t,p} - \hat{y}_{s,f,p} \right\|_2^2$ .

However, with the inverse problem the solution may be sensitive to noise. To solve this, the regularisation may be used to achieve a unique and robust solution for the inverse problem. The regularisation may introduce the prior knowledge of the overall image volume X and/or the motion transformation in the solving process. Thus, according to one embodiment, a regularization term $\Psi$ that modifies the error function in order to penalize certain values of the overall volume X and/or the motion transformation $M_f$ may be used. The regularization term may be used so that the error

becomes: $\left\| y_{s,t,p} - \hat{y}_{s,f,p} \right\|_2^2 + \Psi$ , where $\Psi$ is a regularization functional or term, e.g., such as a denoising network or temporal Total-Variation. The regularization functional may be used to smoothen the images. The regularization term may be used to avoid undesirable values of the overall image volume X, that is the regularization term is defined as follows: $\Psi(X)$. Avoiding undesirable values of the the overall image volume X may result in or induce an avoiding of certain values of the image volume $X_p$ per cardiac phase. Alternatively, or additionally, the regularization term may be used to avoid undesirable motion transformations, that is the regularization term is defined as follows: $\Psi(X, M_f)$. In this case, the processing step may, for example, be performed in parallel for all cardiac phases p of a current frame f so that the regularization term $\Psi$ may be defined for the the overall image volume $X = \{X_p\}_{p=1,...,M}$ of the current frame f.

According to one embodiment, the execution of the machine executable instructions causes the computational system to define the stacks using at least one of: slice order, angulation and center of stacks, so as to minimize artifacts arising from saturation of spins from earlier acquisitions where stacks overlap.

According to one embodiment, the acquisition of the k-space data is performed according to a fast acquisition of low-resolution images or according to an acquisition of high in-plane resolution images. This embodiment may enable to split image acquisition into multiple phases with a different tradeoff between spatial resolution and frame rate: performing fast acquisition of low-resolution images with rapidly varying orientation to build an initial model for the respiratory motion transform and to determine a "bounding box" for the heart or performing acquisition of high in-plane resolution data to generate the 3D+time diagnostic heart image.

According to one embodiment, the acquisition of the k-space data is performed according to a multi-band excitation technique.

According to one embodiment, the execution of the machine executable instructions causes the computational system to identify during the acquisition of the k-space data, the cardiac phases using at least one of: a pilot tone system, an Electrocardiogram, ECG, system, a Vectorcardiography, VCG, system, a camera-based subject monitoring system and a self-navigation system. This may enable to accurately map acquisition times to cardiac phases.

According to one embodiment, the execution of the machine executable instructions causes the computational system to determine for each frame f an acquisition time $t_f$ that resolves the cardiac phases and during which the respiratory motion is frozen, the determining of the acquisition time $t_f$ being performed using a predicted periodicity of the respiratory motion of the subject.

According to one embodiment, the medical system comprises the magnetic resonance imaging system. This may be advantageous as it may enable the acquisition and the adaptation of the acquisition in real-time based on previously acquired data. Alternatively, the MRI system may not be part of the medical system e.g., the medical system may be configured to connect to the MRI system e.g., through a network such as a LAN or Internet.

According to one example, another MRI system may be configured to acquire another k-space data from a thoracic region of another subject in stacks of slices. The two subjects may be similar. The computation system may be configured to perform the processing step using the acquired k-space data from the two MRI systems. This embodiment may advantageously be used for processing by the computational system data acquired by and received from multiple MRI systems in a hospital, wherein the computational system may be provided as a supercomputer in the hospital.

According to one example, transformations for each respiratory motion state from the reference state to the current state may be initialized by combining data from several diastolic heart phases and reconstructed for using a fast linear unfolding via SENSE. This may be possible if the subsampling pattern is chosen to yield regular and not too aggressive undersampling. Indeed, if the (in general irregular) undersampling for a number of consecutive heart phases can be combined to yield a regular undersampling pattern, the SENSE algorithm may be used for fast reconstruction. During diastolic heart phases, about 500-700 ms after the R-peak of the ECG, the heart does not move much, so combining three to five heart phases may not lead to motion artifacts. The resulting images may be used to determine deformation fields between respiratory states.

In another aspect the invention relates to a computer program comprising machine executable instructions for execution by a computational system; wherein execution of the machine executable instructions causes the computational system to: controlling a magnetic resonance imaging system to acquire k-space data from a thoracic region of a subject in stacks of slices, each stack s having a respective orientation, wherein the k-space data is acquired in a set of frames per slice, each frame f having k-space data $y_{s,f}$ that is aquired during an acquisition time $t_f$, each frame $y_{s,t}$ comprising k-space data $y_{s,f,p}$ of each cardiac phase p that is covered by the acquisition time $t_f$; and processing the acquired data cardiac phase-wise for determining per cardiac phase p a three-dimensional, 3D, cardiac image that is motion corrected, the determination being performed by minimizing an error between image data representing $x_{s,f,p}$ the k-space data $y_{s,f,p}$ of a current cardiac phase p and a corresponding prediction $\hat{x}_{s,f,p}$ that is obtained from an estimate $X_p$ of a 3D cardiac image.

In another aspect the invention relates to a method comprising: controlling a magnetic resonance imaging system to acquire k-space data from a thoracic region of a subject in stacks of slices, each stack s having a respective orientation, wherein the k-space data is acquired in a set of frames per slice, each frame f having k-space data $y_{s,f}$ that is aquired during an acquisition time $t_f$, each frame $y_{s,t}$ comprising k-space data $y_{s,f,p}$ of each cardiac phase p that is covered by the acquisition time $t_f$; and processing (referred to as processing step) the acquired data cardiac phase-wise for determining per cardiac phase p a three-dimensional, 3D, cardiac image that is motion corrected, the determination being performed by minimizing an error between image data representing $x_{s,f,p}$ the k-space data $y_{s,f,p}$ of a current cardiac phase p and a corresponding prediction $\hat{x}_{s,f,p}$ that is obtained from an estimate $X_p$ of a 3D cardiac image.

The following may be an example method for determining the 3D+time image volume.

1. Data may be continuously acquired in multiple orientations choosing a new stack orientation (angulation, offset, readout, PE, number of slices) depending on the already acquired data.

2. Cardiac synchronization can be achieved using the ECG, self-navigation or another external sensor.

3. During acquisition, Joint Reconstruction of multi-orientation 2D+t data into an isotropic 3D+t volume may be performed with the available data

Data may be acquired in frames of ~50ms, effectively freezing respiratory motion and resolving cardiac phases which are denoted by p

For each frame f at time t, a deformation transformation $M_f$ is obtained which maps a reference motion state to the motion state at time t.

For each stack s, a resampling matrix exists which accounts for the transformation from the 3D isotropic volume to the current measured slice.

The measured profiles are accounted for in the encoding matrix $E_{s,f,p}$

The joint reconstruction is the obtained by minimizing

$$\left\| y_{s,f,p} - E_{s,f,p} R_s M_f X_p \right\|_2^2 + \Psi(X)$$

$\Psi$ is an optional regularization functional, e.g., a denoising network or simple temporal Total-Variation.

4. Based on current measured data, reconstruction, heart rate and respiration state a new stack orientation and acquisition settings are determined using a policy optimized using Deep Reinforcement Learning. This may lead to minimal scan times. Alternatively, the orientation of the next stack can be selected based on a fixed policy (e.g., random).

According to one embodiment, the execution of the machine executable instructions causes the computational system to identify during the acquisition, the cardiac phases using a vital sign detection system. The vital sign detection system may detect vital sign signals. The vital sign signal may represent an R-peak in the subject's electrocardiogram. The vital sign detection system comprises a camera configured to acquire image frames from an examination zone, a signal processor to derive vital sign information from the acquired image frames, an illumination controller to control illumination of the examination zone and generate temporal modulations of the illumination and synchronise the camera frame rate with the modulated illumination, wherein a signal analyser to detect the modulation depth of image frames' detected between the successive image frames is used and the illumination controller is configured to generated wavelength band modulations of the illumination of the examination zone and syncrhonize the camera frame rate in dependence of the modulation depth.

The vital sign detection system's camera acquires image frames from the examination zone, notably of a subject to be monitored that is placed in the examination zone. The examination zone with the subject are illuminated by an illumination arrangement that is configured to illuminate predominantly a region-of-interest of the subject, in particular an area of the subject's bare skin, so that the camera may acquire the image frames from the illuminated subject in (non-specular) reflection. The illumination arrangement may be configured as an in-bore illumination system. From the acquired image frames the signal processor derives one or more vital sign signals. In particular, temporal variations in blood volume in the subject's tissue lead to variations in absorption and reflection of the illumination's light. Hence, from the image frames a temporal rPPG-signal may be derived. The illumination contains a temporal modulation and the camera frame rate is synchronised with the temporal modulation. This enables that the signal processor to eliminate baseline illumination from the image frames, and isolate the contribution of the vital sign (e.g. blood flow) from the image frames. Accordingly, the dynamic range and hence also the signal-to-noise ratio of the vital sign signal is increased. Further, the illumination may be generated by an illumination arrangement that illuminates the examination room in which the vital sign detection system is located.

In a preferred embodiment of the vital sign detection system, the signal processor may compute differences between successive image frames. These successive image frames are selected with respect to the temporal modulation of the illumination such that the modulation phases of the illumination are different in the respective image frames. This allows to eliminate the baseline contribution of the illumination from the image frames and retain the vital sign signal at higher signal-to-noise ratio.

In a further preferred embodiment of the vital sign detection system, the illumination system is considered part of the vital sign detection system and is configured to emit illumination having a spectral component in the haemoglobin spectral absorption band. This renders the image frames particularly sensitive to absorption by blood in the subject's tissue in especially the wavelength range of 550-600nm. Consequently, the rPPG-signal is vastly enhanced because the illumination contains a very strong spectral components around the absorption maximum of haemoglobin. This embodiment may be incorporated in a magnetic resonance examination system of which the examination zone is illuminated by white light which includes such a very strong spectral component around the absorption maximum of haemoglobin.

In a practical example, the temporal modulation frequency in in the range 20-60Hz. In this range the modulation frequency is sufficiently high to cover time variations in the vital sign signal, while variations of the illumination by macroscopic external causes are often at a much slower time scale than tens of milliseconds.

In a further practical example, the image frame rate of the camera is twice the temporal modulation of the illumination. Preferably, the camera operation is phase-locked with the modulated illumination. In this example, any pair of image frames adjacent in time are acquired at opposite modulation phases of the modulated illumination; e.g. one image frame at illumination on, and one at illumination off. As a result successive images are acquired by the camera with and without the illumination contributing. The difference image between the image of the successive pair predominantly contains the vital sign contribution as the ambient background is cancelled out. This allows to eliminate the baseline illumination and retain the vital sign information by subtraction of the image frames of each pair.

In another example the vital sign detection system may be arranged in a room with external ambient light. The external ambient light may have an inherent temporal modulating frequency that is linked to the mains frequency at which the ambient light is powered. Choosing the temporal modulation frequency of the illumination of the examination zone equal to the inherent temporal modulation frequency avoids beats between the external ambient light and the (additional) illumination of the examination zone. For example, the vital sign detection system may be combined or incorporated with an magnetic resonance examination system of which the examination zone within the magnet bore is illuminated by a bore light incorporated in the magnetic resonance examination system and also by the ambient light from the room in which the magnetic resonance examination system is placed reaches the examination zone. This example of the invention avoids disturbing beats in the vital sign signal between the bore light and the ambient light from the room.

In a practical implementing the synchronisation of the camera frame rate and the illumination modulation is adjusted so that the modulation depth of image brightness is (close to) maximum. Then the camera frame rate and the illumination modulation are in-phase.

The camera may be a monochrome camera as there is only need for brightness differences due to different wavelength bands of the illumination. Notably, the synchronisation does not need the formation of colour images.

In another embodiment the vital sign detection system, comprises a signal analyser to detect the modulation depth of image frames' detected brightness between successive image frames. The illumination controller is configured to generate wavelength band modulations of the illumination of the examination zone and synchronise the camera frame rate in dependence the modulation depth. The image brightness is different for the respective wavelength bands. This is for example owing to wavelength dependence of absorption and reflection from subject (e.g. patient to be examined) in the examination zone. Further, wavelength dependence of the detection sensitivity of the camera for the respective wavelength bands may add to different image brightness of the acquired image frames. This embodiment is based on an insight that the modulation depth is dependent of the synchronisation of the wavelength modulation and the camera frame rate. The differences between image brightness of successive image frames is largest when the wavelength modulation and the camera frame rate are in-phase. Then each individual image frame is associated with an image from illumination from one wavelength band. When the wavelength modulation and the camera frame rate are out-of-phase (or in anti-phase) then each individual image frame's image brightness is effectively an average over different wavelength bands and the difference between image brightness of successive image frames is minimal, or even zero. Accordingly, this embodiment based on wavelength modulation achieves synchronisation of the camera frame rate and the illumination modulation based on the acquired stream of the acquired image frames. In this way, synchronisation is accurate and implemented in a simple manner. In particular, there is no need to accurately adjust signal transmit times due to different lengths of signal leads to the camera and the illumination controller. A simple implementation the illumination controller is configured to compute the average brightness values (over the pixels of each of the image frames) of the image frames. The Fourier transform of this time series of average brightness is computed, e.g. by way of a sliding window of a predetermined number of image frames. The average brightness values may be derived from a selected region-of-interest in the image frames in which differences between illumination with different wavelength is relatively high. Further, the modulation depth of the wavelength band modulation may be measured while the rate of the wavelength band modulation is much slower than the image frame rate. Then the temporal illumination pattern approaches a rectangular waveform. This may be implemented in practice in an easy way be generating the wavelength band modulation by switching on/off different sets of colour LEDs and using an image frame rate in the range of 10-100Hz, so that the modulation depth can be measured within a second. Alternatively, an additional object having marked colour differences may be arranged in the camera's range. For example a hardware test-image on a sticker may be used. The accurate synchronisation of the wavelength band of the illumination with the camera frame rate then corresponds with the dominant frequency component (i.e. having the largest amplitude) in the series of average brightness values. In the simple implementation in which only two different illumination wavelengths are employed, a sliding window average of the modulus of the difference of the brightness of subsequent image frames represents the modulation depth.

Control of the camera frame rate relative to the rate of the wavelength band modulation of the illumination may be achieved by way of a feedback loop in which the modulation depth of the modulation depth of the image frames is maximum. Positive and negative phases delays in the time course of the illumination modulation may be introduced by this feedback loop and the maximum modulation depth is then obtained at the camera frame rate being accurately in-phase in a stable manner with illumination wavelength band modulation.

In a practical embodiment the illumination wavelength band modulation and the camera frame rate are controlled by a common processor of the vital sign detection system. Upon arrival of the current image frame at the processor, the wavelength band of the illumination is swithced. This may be implemented by LED-based illumination and switch on/off of different (sets) of LEDs operating at the respective wavelength bands. In this way the frequencies of the camera frame rate (i.e. the image frame rate) and of the illumination wavelength band modulation are at equal frequencies. Any phase delays that may be introduced by different transit times between control signals for the camera and the illumination may be corrected for by maximising the modulation depth of the illumination. This correction may be derived from the image frames without specific determination of the individual signal delays.

In another implementation an interleaved re-synchronisation measurement in which a $\pi/2$-phase angle is introduced in the wavelength band modulation and the image frame rate. Then the modulation depth has a high sensitivity for small phase variations in the synchronisation of the image frame rate and the illumination wavelength band modulation. The sign of the variation of the modulation depth variation with a small additional phase determines whether to (in)(de)crease the phase between the image frame rate and the illumination wavelength band modulation in order tore-synchronise into the in-phase synchronisation.

The vital sign signal from the vital sign detection system may be employed as a trigger signal for another imaging system, such as a magnetic resonance examination system, or a computed-tomography. Then the vital sign detection system of the invention functions as a synchronisation system for the imaging system to acquired image data, such as k-space profiles, x-ray absorption profiles or sinograms, synchronised the detected vital sign. For example, the vital sign may be a patient's heart rate, so that the vital sign signal represents an R-peak in the patient's electrocardiogram and the image data are acquired synchronised with the patient's heart rate. This enables to avoid cardiac motion artefacts in the images reconstructed form the acquired image data.

The camera-based implementation of the vital sign detection system of the invention in clinical practice achieves inter alia (i) better region-of-interest detection (or skin detection) in the multi-dimensional color space, i.e. the DC color of objects/skin can be used for better skin and non-skin segmentation; (ii) better vital sign signal (e.g. PPG-signal) signal quality, i.e. pulsatile component has characteristic features in multi-dimensional colour space, which can be used to differentiate from the distortions (e.g. body motion).

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,

Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

K-space data is defined herein as being the recorded measurements of radio frequency signals emitted by atomic spins using the antenna of a Magnetic resonance apparatus during a magnetic resonance imaging scan. Magnetic resonance data is an example of tomographic medical image data. Motion resolved k-spaced data is k-space data that is either binned, sorted, or soft gated according to one or more motion phases of a subject. For example, the motion resolved k-space data could be sorted, binned, or soft gated according to the respiratory and/or cardiac phase of the subject.

A Magnetic Resonance Imaging (MRI) image or MR image is defined herein as being the reconstructed two- or three-dimensional visualization of anatomic data contained within the magnetic resonance imaging data. This visualization can be performed using a computer.

BRIEF DESCRIPTION OF THE DRAWINGS

In the following preferred embodiments of the invention will be described, by way of example only, and with reference to the drawings in which:

Fig. 1 illustrates an example of a medical system;
Fig. 2 shows a flowchart of a method of using the medical system of Fig. 1;
Fig. 3 depicts a diagram of an example optimization approach;
Fig. 4 shows a schematic side elevation of a tomographic imaging system in which an embodiment of a vital sign detection system of the invention is incorporated;
Fig. 5 shows a diagrammatic representation of the time evolution of the modulated illumination, the signal acquired by the camera and the signal presented vital sign information;
Fig. 6 shows a schematic side elevation of a tomographic imaging system in which another embodiment of a vital sign detection system of the invention is incorporated; and
Figs. 7a-b show plots of the intensity.

DETAILED DESCRIPTION OF EMBODIMENTS

Like numbered elements in these figures are either equivalent elements or perform the same function. Elements which have been discussed previously will not necessarily be discussed in later figures if the function is equivalent.

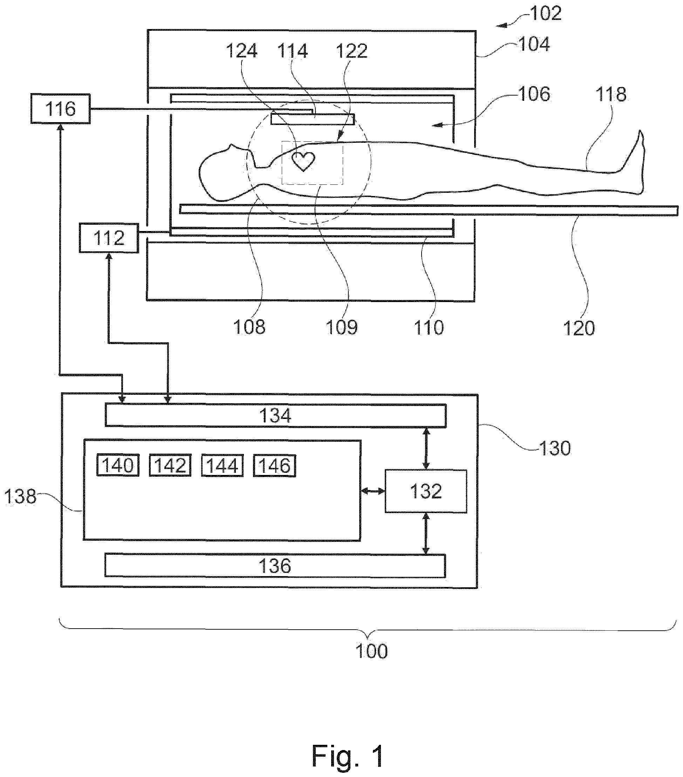

Fig. 1 illustrates an example of a medical system 100. The medical system 100 is shown as comprising a magnetic resonance imaging system 102 and a computer 130. The magnetic resonance imaging system 102 comprises a magnet 104. The magnet 104 is a superconducting cylindrical type magnet with a bore 106 through it. The use of different types of magnets is also possible; for instance it is also possible to use both a split cylindrical magnet and a so called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils.

Within the bore 106 of the cylindrical magnet 104 there is an imaging zone 108 where the magnetic field is strong and uniform enough to perform magnetic resonance imaging. A predetermined region of interest 109 is shown within the imaging zone 108. The magnetic resonance data that is acquired typically acquired for the region of interest. A subject 118 is shown as being supported by a subject support 120 such that at least a portion of the subject 118 is within the imaging zone 108 and the predetermined region of interest 109.

Within the bore 106 of the magnet there is also a set of magnetic field gradient coils 110 which is used for acquisition of preliminary magnetic resonance data to spatially encode magnetic spins within the imaging zone 108 of the magnet 104. The magnetic field gradient coils 110 connected to a magnetic field gradient coil power supply 112. The magnetic field gradient coils 110 are intended to be representative. Typically magnetic field gradient coils 110 contain three separate sets of coils for spatially encoding in three orthogonal spatial directions. A magnetic field gradient power supply supplies current to the magnetic field gradient coils. The current supplied to the magnetic field gradient coils 110 is controlled as a function of time and may be ramped or pulsed.

Adjacent to the imaging zone 108 is a radio-frequency coil 114 for manipulating the orientations of magnetic spins within the imaging zone 108 and for receiving radio transmissions from spins also within the imaging zone 108. The radio frequency antenna may contain multiple coil elements. The radio frequency antenna may also be referred to as a channel or antenna. The radio-frequency coil 114 is connected to a radio frequency transceiver 116. The radio-frequency coil 114 and radio frequency transceiver 116 may be replaced by separate transmit and receive coils and a separate transmitter and receiver. It is understood that the radio-frequency coil 114 and the radio frequency transceiver 116 are representative. The radio-frequency coil 114 is intended to also represent a dedicated transmit antenna and a dedicated receive antenna. Likewise the transceiver 116 may also represent a separate transmitter and receivers. The radio-frequency coil 114 may also have multiple receive/transmit elements and the radio frequency transceiver 116 may have multiple receive/transmit channels. For example, if a parallel imaging technique such as SENSE is performed, the radio-frequency coil 114 will have multiple coil elements.

The transceiver 116 and the gradient controller 112 are shown as being connected to the hardware interface 134 of the computer 130.

The subject 118 has been positioned within the bore of the magnet 106 such that a thoracic region 122 of the subject 118 is positioned within a predetermined region of interest 109. The subject's heart 124 is located within the predetermined region of interest 109. When the lines of k-space data 144 are acquired the heart 124 will automatically be imaged.

The medical system 100 is further shown as comprising a computer 130. The computer 130 is intended to represent one or more computing or computational devices located at one or more locations. The computer 130 is shown as containing a computational system 132. The computational system 132 is intended to represent one or more computational systems that could for example be one or more processing cores located at one or more locations. Various combinations of computational systems 132 and/or computers 130 could be connected and work together cooperatively using a network. The computational system 132 is shown as being in communication with a hardware interface 134, a user interface 136, and a memory 138. The hardware interface 134 is an interface which enables the computational system 132 to communicate with and/or control other components of the medical system 100 such as the magnetic resonance imaging system 102. The user interface 136 is a user interface that enables an operator of the medical system 100 to control and operate the medical system 100. The memory 138 is intended to represent various types of memory which may be in communication with the computational system 132.

The memory 138 is shown as containing machine-executable instructions 140. The machine-executable instructions 140 are instructions which enable the computational system 132 to perform various processes and tasks such as image processing, numerical calculations and control of the magnetic resonance imaging system 102. The memory 138 is further shown as containing pulse sequence commands 142. The pulse sequence commands as used herein are commands or data which may be converted into commands which enable the computational system 132 to control the magnetic resonance imaging system 102 to acquire k-space data 144.

The pulse sequence commands 142 in this example are according to a free-running cardiac magnetic resonance imaging protocol. The pulse sequence commands are configured to repeatedly acquire lines of k-space data for the predetermined region of interest 109. As the lines of k-space data are repeatedly or continuously acquired the free-running nature of the pulse sequence commands 142 means that the k-space data 144 will be acquired for a variety of motion states or phases of the subject 118.

They are not depicted in this Fig. but there may be systems or system for measuring the respiratory and/or cardiac phase for the movement of the subject 118. The memory 138 is further shown as containing a three-dimensional cardiac image 146 that has been reconstructed from the k-space data 144.

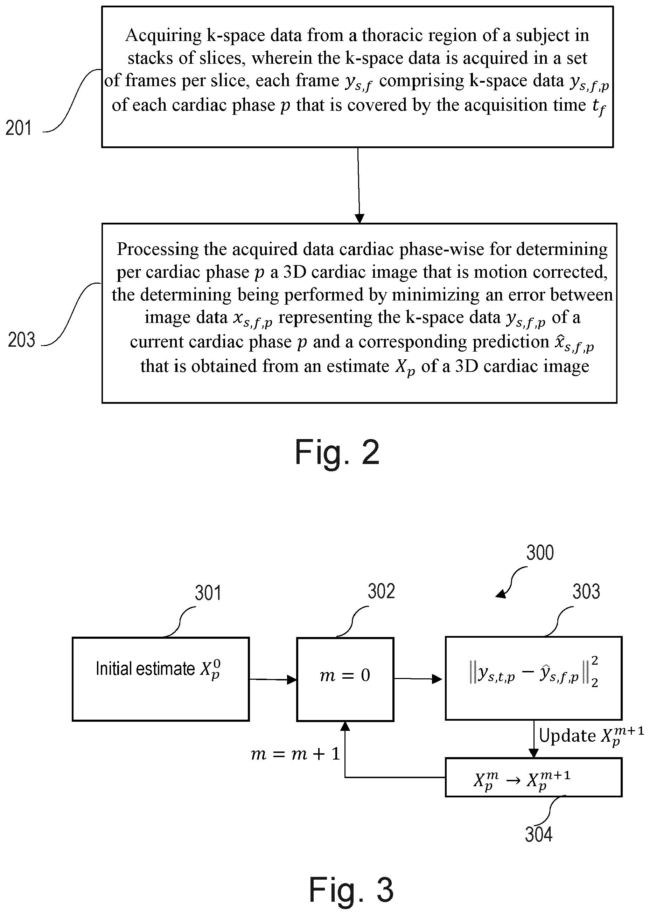

Fig. 2 is a flowchart of a method for obtaining cardiac image data in accordance with an example of the present subject matter. For the purpose of explanation, the method described in Fig. 2 may be implemented in the system illustrated in Fig. 1 but is not limited to this implementation. In this example, the image data $x_{s,f,p}$ representing the k-space data $y_{s,f,p}$ may be the k-space data, that is $x_{s,f,p} = y_{s,f,p}$ and thus $\hat{x}_{s,f,p} = \hat{y}_{s,f,p}$.

The MRI system 102 may acquire data in step 201 in stacks of slices. The MRI system 102 may, for example, acquire the data using the free-running cardiac magnetic resonance imaging protocol. Each stack of the stacks may comprise parallel slices. Each stack may consist of a number of slices within a predefined range. The range may, for example, be 20 to 40 slices. The resolution of the slices may, for example, be smaller than or equal to a predefined minimum resolution e.g., the minimum slice resolution may be 1×1 mm in plane. The slice thickness may be smaller than a predefined maximum thickness. The maximum thickness may, for example, be 3 mm. Each stack may be acquired over a period of time e.g., of around 20 seconds. The slices of each stack may, for example, be acquired in an interleaved pattern e.g., alternating odd-even. One slice may be acquired at a time.

The k-space data is acquired in a series of frames per slice. Using frames may ensure a dense sampling in both space and time. Each frame $f$ may be acquired during an acquisition time $t_f$. The acquisition time $t_f$ may be the same for all frames. Alternatively, the acquisition time $t_f$ may be provided distinct for each frame or for each group of frames. Each frame $f$ may have k-space data referred to as $y_{s,f}$. Each frame $y_{s,f}$ comprises k-space data referred to as $y_{s,f,p}$ of each cardiac phase p that is covered by the acquisition time $t_f$. $y_{s,f,p}$ refers to k-space data acquired for a cardiac phase $p$ in a frame $f$ belonging to a slice of a stack $s$.

The present subject matter may enable to combine k-space data provided by the stacks to produce an image that has a higher spatial resolution than the original images. The combination may be performed in the spatial domain. For that, a volumetric reconstruction may be performed in step 203. The volumetric reconstruction may be performed based on a forward modelling such that the volumetric reconstruction is provided as the solution to an inverse problem. The inverse problem tries to find an underlying 3D image $X_p$ for different cardiac phases given acquired k-space data by the MRI system. The acquired data may be processed per cardiac phase (or cardiac phase-wise) for determining per cardiac phase $p$ a 3D cardiac image that is motion corrected. This determination is performed by minimizing an error between the k-space data $y_{s,f,p}$ of a current cardiac phase p and a corresponding prediction $\hat{y}_{s,f,p}$ that is obtained from an estimate $X_p$ of a 3D cardiac image.

Fig. 3 shows an example optimization algorithm 300 for obtaining the 3D image $X_p$ for each cardiac phase p. The optimization algorithm 300 may be described with blocks 301 to 304. For each distinct cardiac phase p, the following may be performed to obtain the optimal 3D image $X_p$. The 3D image may, for example, be initialized to obtain $X_p^{m=0}$ as indicated with block 301. The initialization may, for example, be performed using one acquired reference stack. The reference stack may, for example, not be part of the $n$ acquired stacks. The reference stack may, for example, be used for the preliminary initialization of the reconstructed volume, to obtain $X_p^0$. The initialization may, for example, be performed before starting the acquisition of the $n$ stacks. After initialization, a current prediction $\hat{y}_{s,f,p}^{m=0}$ may be obtained from the current 3D image $X_p^0$. The estimate $\hat{y}_{s,f,p}^{m=0}$ may be compared with the first acquired k-space data $y_{s,f,p}$ of the current cardiac phase p, in order to determine an error between the k-space data $y_{s,f,p}$ prediction $\hat{y}_{s,f,p}$ as indicated in block 303. Based on the comparison, the next 3D image $X_p^{m+1}$ may be determined (block 304) such that the error is minimized. After that, a current prediction $\hat{y}_{s,f,p}^{m+1}$ may be obtained from the current 3D image $X_p^{m+1}$ for a current cardiac phase p. The estimate $\hat{y}_{s,f,p}^{m+1}$ may be compared with the subsequent acquired k-space data $y_{s,f,p}$ of the current cardiac phase p, in order to determine an error between the k-space data $y_{s,f,p}$ and prediction $\hat{y}_{s,f,p}^{m+1}$. Based on the comparison, the next 3D image $X_p^{m+2}$ may be determined such that the error is minimized and so on until reaching an iteration that provides an optimal 3D image $X_p$.

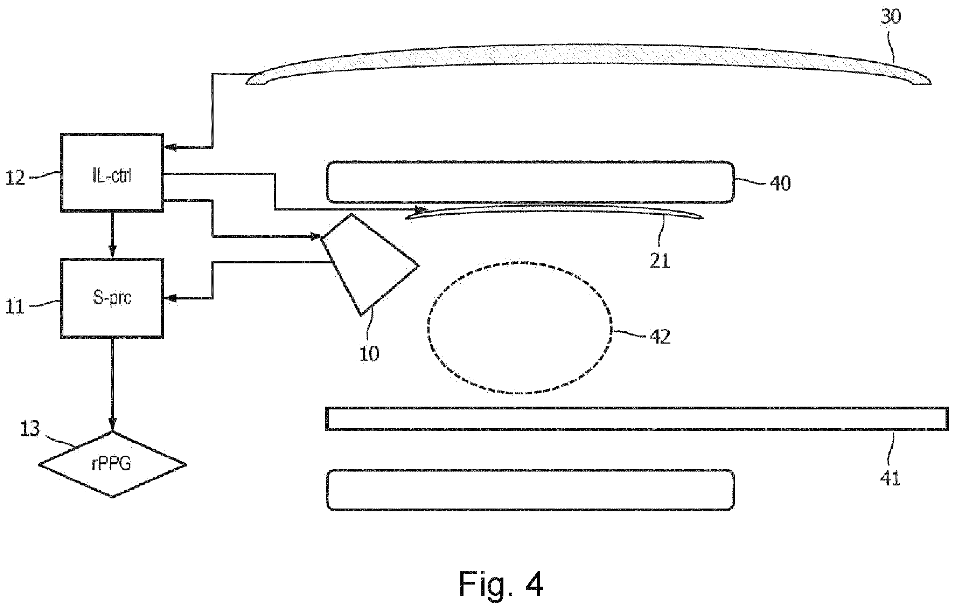

Fig. 4 shows a schematic side elevation of a tomographic imaging system in which an embodiment of a vital sign detection system of the present subject matter is incorporated. A tomographic imaging system 40 is schematically represented by its frame 41, patient carrier 42 and the examination zone 43 defined by the gantry. For example, for a computed-tomography system the frame is formed by the gantry in which an x-ray source and x-ray detector are rotatably mounted to rotated around the examination zone. In another example for a magnetic resonance examination system the frame constitutes the structure that carries the magnet assembly and the examination zone is defined by the volume in which the magnet assembly applies a uniform magnetic field and accurately linear gradient magnetic fields. For example the examination zone is formed by (part of) the magnet bore of a cylindrical configuration of the magnet assembly or formed by the space between opposite magnet pole shoes of a an open type magnet assembly. An illumination system 20 is provided to illuminate the examination zone 43 and includes the illumination arrangement 21 and the illumination controller 12. The illumination controller 12 drives the illumination arrangement 21 so as to generate an amplitude modulated illumination of the examination zone. The illumination arrangement may include an array of LED white light sources that have a significant spectral component in the green wavelength range of 550-600nm. In this wavelength range, the brightness level of the LED white light sources may be higher than that of infrared illumination without running into safety issues. The illumination controller 12 is typically configured to drive the illumination arrangement 21 in the amplitude modulated mode at a modulation frequency in the range of 35-45Hz, for example at 40Hz. This modulation frequency range is beyond the temporal resolution of the human visual system, so that the patient to be examined and the operator or support staff are not disturbed by flickering of the illumination system. The illumination control also communicates to the camera 10 to synchronise the camera's frame rate at which image frames from the examination zone (and the patient to be examined) are acquired with the amplitude modulation of the illumination system. In this way is it achieved that the camera acquis images at the respective modulation phases of the illumination. The image frames form the camera are applied to the signal processor 11 which drives the vital sign information 13, i.e. the rPPG-signal, from the image frames. In particular the signal processor may subtract image frames for the respective modulation phases the isolate the vital signal information. Good results are achieved by subtraction of successive image frames from the different modulation phases. This may be successive images from the examination zone for illumination on and off. Background signal is then removed in the subtraction that predominantly pertains to vital sign information of the patient to be examined. Because the modulation frequency is much higher than temporal variations of ambient light e.g. from ambient illumination 30 of the room, or other external causes, residual signal in the subtraction images is small, notably inversely proportional to the modulation frequency. The illumination controller may further comprise phase-locking circuitry to phase-lock the illumination system with ambient illumination to avoid beats between the illumination of the examination zone with periodicity in the light output of the ambient illumination. This is beneficial in the event the ambient illumination is directly driven at mains frequency (50-60Hz). This enables the vital sign detection system of the present subject matter to be installed in an environment where there is ambient illumination directly driven at mains frequency. This facilitates easy siting of a tomographic imaging system with the vital sing detection system of the present subject matter.

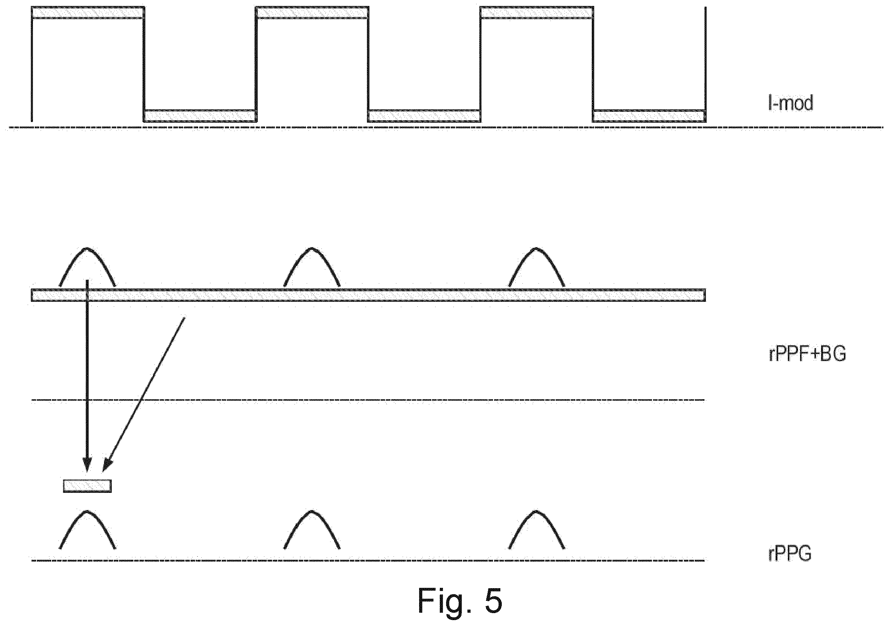

Fig. 5 shows a diagrammatic representation of the time evolution of the modulated illumination, the signal acquired by the camera and the signal representing vital sign information. The trace I-mode represents the amplitude modulation of the illumination with time. The trace has alternating modulation phases 61,62 of high and low brightness. The race rPPG-BG represents a remote PPG signal added to a background signal level. The rPPG signal is high in the high illumination phases and in the low(dark) illumination phases on a background signal is detected by the camera. The signal trace rPPG is formed from subtraction of successive image frames at the alternate modulation phases of the illumination modulations.

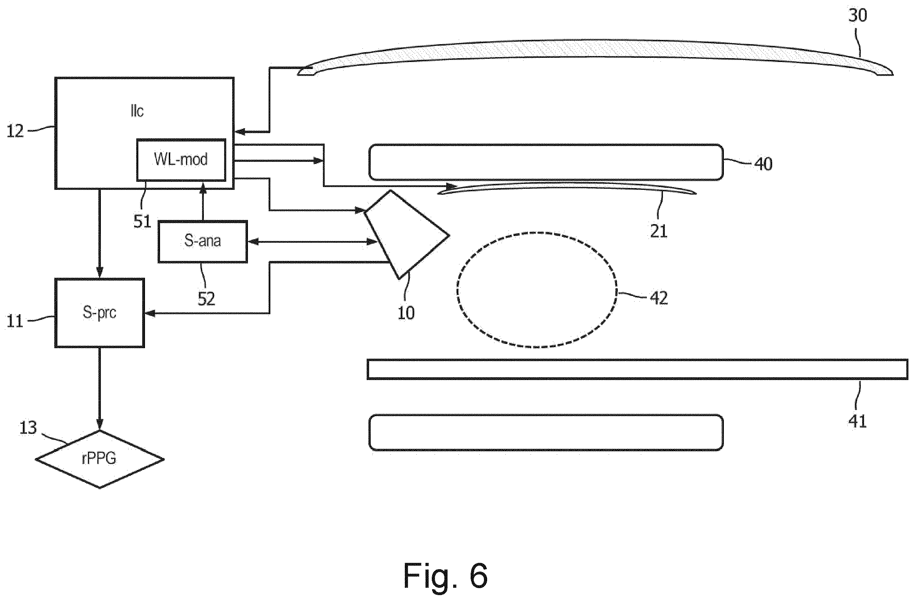

Fig. 6 shows a schematic side elevation of a tomographic imaging system in which another embodiment of a vital sign detection system of the present subject matter is incorporated. In the implementation of Fig. 6, the illumination controller is provided with a wavelength modulator 51 that controls the illumination arrangement 21 to operate at temporal wavelengths. For example the illumination arrangement 21 may be fitted with different colour LEDs that are alternatingly switched by the wavelength modulator 51. The vital sign detection system in this implementation is provided with a signal analyser that is circuited to receive the image frames from the camera 10. The signal analyser 52 is configured, i.e. software functionality to determine the modulation depth of the image frames' brightness values between image frames dependent on the relative phase between the camera frame rate and the wavelength modulation of the illumination. On the basis of the detected modulation depth of the image frames, the illumination controller 12 generates wavelength band modulations of the illuminations emitted by the illumination arrangement. And on the basis of the detected modulation depth as a function of the relative phase, the camera frame rate is synchronised with the modulated illumination in that the relative in-phase of the illumination wavelength modulation and the camara frame rate is found at maximum wavelength modulation depth. In particular the signal analyser determines maximum modulation depth dependent on the temporal modulation rate of the illumination. Then the camera frame rate is set and synchronised with the frame rate illumination modulation being maximum. That is the camera frame rate in synchronised with the illumination modulation on the basis of information of the camera frame rate. This may be implemented in that the wavelength modulation depth between successive image frames is measured continuously by the signal analyser 52 that adjusts the camara frame rate and the illumination modulation and their relative phase kept in-phase by maintaining maximum wavelength modulation dept, or by maintaining a wavelength modulation depth above a pre-set threshold value.

A further detail of the implementation of the present subject matter concerns a metric to measure the quality of synchronization between the light source (switching phase) and camera (sampling phase). The quality metric is performed online (in a real time fashion) to assess the quality of each newly arriving frame. If the synchronization is perfectly in-phase, the contrast between the multi-wavelength DC values will be the maximum (e.g. steep/large contrast between the values in the DC vector); if the synchronization is poor (out-of-phase), the contrast will be reduced as the frame is taken from a joint portion of two wavelengths (e.g. different wavelengths have contributions in a single frame). Hence, the DC vector will be flatter. In the worst case that the synchronization is completely anti-phase, the vector will be flat. Therefore, we define a DC vector that measures the DC values of the region-of-interest pixels at different wavelengths (e.g. use 3-wavelength as the showcase here) as:

$$DC = [mean(ROI_{wavelength1}), mean(ROI_{wavelength2}), mean(ROI_{wavelength3})]$$

To ease the interpretation and optimization, we normalize the DC vector by its total energy (e.g. Li-norm or $L_2$-norm) as the total strength does not matter here, only the contrast matters:

$$\overline{DC} = \frac{DC}{sum(DC)}$$

Which is the normalized DC vector of multi-wavelength values. This vector is measured for each new frame in real time.

In case of poor synchronization, a time delay (for camera) is determined such that the $\overline{DC}$ vector has the largest contrast, which means that it needs to deviate from the [1,1,1] direction (e.g. flat) as much as possible. Thus, the below optimization function may be employed:

$$\max_{delay}\left(\left\|\overline{DC}_{delay} - \frac{[1,1,1]}{3}\right\|_2\right)$$

This maximises the L2-distance between the normalized DC vector and the undesired [1,1,1] direction. Note other distances can be used as well, such as maximizing the (cosine) angle between the two vectors. The output of this optimization function is a time delay that the camera needs compensate its unsynchronized phase and to be synchronized with the light source again.

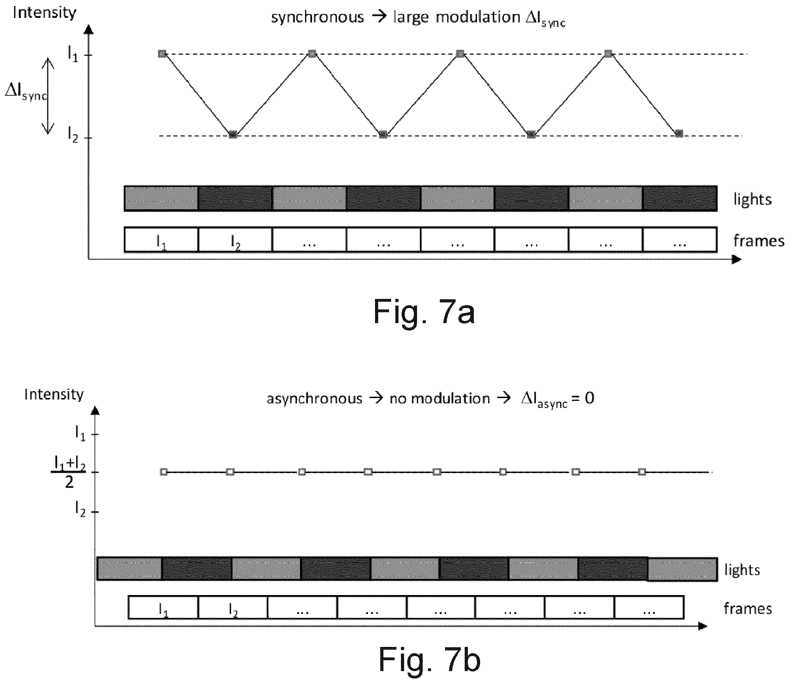

In some embodiments, the average intensity $I_i$ of each frame i is calculated. If the synchronization is perfect, then the modulation amplitude $I_i$ is maximal as sketched in Fig. 7a. If light switching and image acquisition are becoming out of sync, the modulation amplitude decreases as in Fig. 7b. In some embodiments, it is proposed to evaluate this modulation amplitude continuously and to adapt preferentially the phase of the light switching frequency if a decrease is detected. Alternatively, small positive or negative delays are repeatedly introduced in the time course of the light switching. One of the effects of this is that the light switching and frame acquisition is kept synchronous. In some embodiments, the algorithm can be adapted in the temporal domain, in other embodiments, the algorithm is adapted in the spatial domain. In the temporal domain, it is known that the modulation frequency of light source (n times the camera sampling rate), will lead to a delay that can make the spectrum peak of the video signal at the modulation frequency as high as possible. To optimize in the spatial domain, an optimized subset of pixels to increase the DC contrast between the wavelength bands in this subset is being used. This allows to decrease the lag between the acquisitions.

In some embodiments, the rPPG data acquisition may be altered, for instance stopped for a few frames in order to interleave a synchronization measurement. For the synchronization measurement in this embodiment, the phase of the light switching may be deliberately offset by quarter of a cycle to introduce a 90° phase angle between light switching and frame acquisition, effectively realizing a situation in between Fig. 7a and 7b. This sets the system to the operating point with maximal derivative of modulation amplitude with respect to the phase. This may lead to the following technical effects: a) small deviations in phase result in a maximal change of modulation amplitude, and b) the sign of this amplitude change carries information of whether to increase or decrease the phase. After this synchronization measurement which may last only a few cycles, the system may be switched back to in-phase to continue with rPPG data acquisition.

One of the challenges overcome by the present subject matter is that the light produced by the modulation arrangement 21 is not optimal and synchronous. In this embodiment, the light sources from the modulation arrangement 21 are controlled from the same computer that ultimately receives the frames, the time point of frame arrival can be used for frequency synchronization. Therefore, whenever a frame arrives at the signal processor 11, the light sources of the modulation arrangement 21 are switched. One of the technical advantages of this approach is that both the camera 10 and the light sources are operated at exactly the same frequency (and without any cumulative error). However, the phase (delay) between both signals is still unknown and the method described in the present disclosure can be used to determine it and fully synchronize light switching and frame acquisition.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

**Claims**

1.    A medical system (100) comprising:

- a memory (138) storing machine executable instructions;
- a computational system (132), wherein execution of the machine executable instructions causes the computational system to:

- control a magnetic resonance imaging system (102) to acquire (201) k-space data from a thoracic region of a subject in stacks of slices, each stack s having a respective orientation, wherein the k-space data is acquired in a set of frames per slice, each frame $f$ having k-space data $y_{s,f}$ that is aquired during an acquisition time $t_f$, each frame $y_{s,t}$ comprising k-space data $y_{s,f,p}$ of each cardiac phase p that is covered by the acquisition time $t_f$;
- process (203) the acquired data cardiac phase-wise for determining per cardiac phase p a three-dimensional, 3D, cardiac image that is motion corrected, the determination being performed by minimizing an error between image data $x_{s,f,p}$ representing the k-space data $y_{s,f,p}$ of a current cardiac phase p and a corresponding prediction $\hat{x}_{s,f,p}$ that is obtained from an estimate $X_p$ of a 3D cardiac image.

2.    The medical system of claim 1, the execution of the machine executable instructions causing the computational system to perform the processing concurrently with the acquisition of the k-space data.

3.    The medical system of claim 1 or 2, the orientations of the different stacks being different, the stacks being acquired consecutively, wherein the execution of the machine executable instructions causes the computational system to: determine an orientation for a current stack of slices using at least one of: acquired data of the previous stacks, heart rate and respiration state of the subject.

4.    The medical system of any of the preceding claims 1 to 3, the execution of the machine executable instructions causing the computational system to: during acquisition of a current stack of the slices, predict an orientation of a subsequent stack of the slices using a policy optimized using a deep reinforcement learning.

5.    The medical system of any of the preceding claims 1 to 4, the obtaining of the prediction $\hat{x}_{s,f,p}$ comprising: $x_{s,f,p} = WX_p$ where $W$ relates spatial locations in the 3D cardiac image $X_p$ and the image data $x_{s,f,p}$ taking into account a motion transformation due to a cardiac motion and/or respiratory motion of the subject.

6.    The medical system of any of the preceding claims 1 to 5, wherein the image data $x_{s,f,p}$ is the acquired k-space data $y_{s,f,p}$, $x_{s,f,p} = y_{s,f,p}$, wherein the obtaining of the prediction $\hat{x}_{s,f,p}$ comprises: $\hat{x}_{s,f,p} = E_{s,f,p}R_sM_fX_p$ where $M_f$ is a motion transformation operator that maps a reference motion state to a motion state at time $t_f$, $R_s$ is a resampling operator which accounts for the transformation from the 3D cardiac image $X_p$ to a current slice of the current frame $f$, $E_{s,f,p}$ is an encoding matrix comprising a coils sensitivity map.

7. The medical system of claim 5 or 6, the motion transformation being performed for a predefined region of interest of the heart of the subject.

8. The medical system of any of the preceding claims 1 to 7, wherein the error between the image data $x_{s,f,p}$ and the prediction $\hat{x}_{s,f,p}$ is defined as follows: $\left\| x_{s,t,p} - \hat{x}_{s,f,p} \right\|_2^2$ .

9. The medical system of claim 8, wherein the execution of the machine executable instructions causes the computational system to: use a regularization term $\Psi$ that modifies the error function in order to penalize certain values of the overall volume X and/or the motion transformation.

10. The medical system of any of the preceding claims 1 to 9, wherein the execution of the machine executable instructions causes the computational system to define the stacks using at least one of: slice order, angulation and center of stacks, so as to minimize artifacts arising from saturation of spins from earlier acquisitions where stacks overlap.

11. The medical system of any of the preceding claims 1 to 10, wherein execution of the machine executable instructions causes the computational system to identify during the acquisition, the cardiac phases using at least one of: a pilot tone system, an Electrocardiogram, ECG, system, a Vectorcardiography, VCG, system, a camera-based subject monitoring system, a self-navigation system, and a vital sign detection system, wherein the vital sign detection system comprises a camera (10) configured to acquire image frames from an examination zone (42), a signal processor (11) to derive vital sign information from the acquired image frames, an illumination controller (12) to control illumination of the examination zone and
generate temporal modulations of the illumination and synchronise the camera frame rate with the modulated illumination, wherein a signal analyser to detect the modulation depth of image frames' detected between the successive image frames is used and the illumination controller is configured to generated wavelength band modulations of the illumination of the examination zone and syncrhonize the camera frame rate in dependence of the modulation depth.

12. The medical system of any of the preceding claims 1 to 11, wherein execution of the machine executable instructions causes the computational system to determine for each frame $f$ an acquisition time $t_f$ that resolves the cardiac phases and during which the respiratory motion is frozen, the determining of the acquisition time $t_f$ being performed using a predicted periodicity of the respiratory motion of the subject.

13. The medical system of any of the preceding claims 1 to 12, the medical system comprising the magnetic resonance imaging system.

14. A computer program comprising machine executable instructions for execution by a computational system; wherein execution of the machine executable instructions causes the computational system to: controlling a magnetic resonance imaging system to acquire k-space data from a thoracic region of a subject in stacks of slices, each stack s having a respective orientation, wherein the k-space data is acquired in a set of frames per slice, each frame $f$ having k-space data $y_{s,f}$ that is aquired during an acquisition time $t_f$, each frame $y_{s,t}$ comprising k-space data $y_{s,f,p}$ of each cardiac phase p that is covered by the acquisition time $t_f$; and processing the acquired data cardiac phase-wise for determining per cardiac phase p a three-dimensional, 3D, cardiac image that is motion corrected, the determination being performed by minimizing an error between image data representing $x_{s,f,p}$ the k-space data $y_{s,f,p}$ of a current cardiac phase p and a corresponding prediction $\hat{x}_{s,f,p}$ that is obtained from an estimate $X_p$ of a 3D cardiac image.

15. A method comprising: controlling a magnetic resonance imaging system to acquire k-space data from a thoracic region of a subject in stacks of slices, each stack s having a respective orientation, wherein the k-space data is acquired in a set of frames per slice, each frame $f$ having k-space data $y_{s,f}$ that is aquired during an acquisition time $t_f$, each frame $y_{s,t}$ comprising k-space data $y_{s,f,p}$ of each cardiac phase p that is covered by the acquisition time $t_f$; and processing the acquired data cardiac phase-wise for determining per cardiac phase p a three-dimensional, 3D, cardiac image that is motion corrected, the determination being performed by minimizing an error between image data representing $x_{s,f,p}$ the k-space data $y_{s,f,p}$ of a current cardiac phase p and a corresponding prediction $\hat{x}_{s,f,p}$ that is obtained from an estimate $X_p$ of a 3D cardiac image.

Fig. 1

Acquiring k-space data from a thoracic region of a subject in stacks of slices, wherein the k-space data is acquired in a set of frames per slice, each frame $y_{s,f}$ comprising k-space data $y_{s,f,p}$ of each cardiac phase $p$ that is covered by the acquisition time $t_f$

201

Processing the acquired data cardiac phase-wise for determining per cardiac phase $p$ a 3D cardiac image that is motion corrected, the determining being performed by minimizing an error between image data $x_{s,f,p}$ representing the k-space data $y_{s,f,p}$ of a current cardiac phase $p$ and a corresponding prediction $\hat{x}_{s,f,p}$ that is obtained from an estimate $X_p$ of a 3D cardiac image

203

## Fig. 2

300

301

Initial estimate $X_p^0$

302

$m = 0$

303

$\left\| y_{s,t,p} - \hat{y}_{s,f,p} \right\|_2^2$

Update $X_p^{m+1}$

$m = m + 1$

$X_p^m \rightarrow X_p^{m+1}$

304

## Fig. 3

Fig. 4

EP 4 361 659 A1

I-mod

rPPF+BG

rPPG

Fig. 5

Fig. 6

EP 4 361 659 A1

Fig. 7a

Fig. 7b

Europäisches
Patentamt

European
Patent Office

Office européen
des brevets

# EUROPEAN SEARCH REPORT

Application Number

EP 22 20 3550

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ODILLE FREDDY ET AL: "Isotropic 3D Cardiac Cine MRI Allows Efficient Sparse Segmentation Strategies Based on 3D Surface Reconstruction", MAGNETIC RESONANCE IN MEDICINE, vol. 79, no. 5, 2 October 2017 (2017-10-02), pages 2665-2675, XP093037375, US ISSN: 0740-3194, DOI: 10.1002/mrm.26923 * Section "Methods" * * figure 1 * | 1,2,5-15 | INV. G01R33/28 G01R33/56 G01R33/563 |
| X | OKTAY OZAN ET AL: "Multi-input Cardiac Image Super-Resolution Using Convolutional Neural Networks", 2 October 2016 (2016-10-02), SAT 2015 18TH INTERNATIONAL CONFERENCE, AUSTIN, TX, USA, SEPTEMBER 24-27, 2015; [LECTURE NOTES IN COMPUTER SCIENCE; LECT.NOTES COMPUTER], SPRINGER, BERLIN, HEIDELBERG, PAGE(S) 246 - 254, XP047364481, ISBN: 978-3-540-74549-5 [retrieved on 2016-10-02] * Sections "Methodology", "Results" * | 1,2,5-15 | |
| X | SAMI UR RAHMAN ET AL: "Upsampling of cardiac MR images: Comparison of averaging and super-resolution for the combination of multiple views", INFORMATION TECHNOLOGY AND APPLICATIONS IN BIOMEDICINE (ITAB), 2010 10TH IEEE INTERNATIONAL CONFERENCE ON, IEEE, PISCATAWAY, NJ, USA, 3 November 2010 (2010-11-03), pages 1-4, XP031849318, ISBN: 978-1-4244-6559-0 * Sections I, II, III * | 1,2,5-15 | |

TECHNICAL FIELDS
SEARCHED      (IPC)

G01R
A61B

-/--

The present search report has been drawn up for all claims

| Place of search | Date of completion of the search | Examiner |
|---|---|---|
| Munich | 5 April 2023 | Streif, Jörg Ulrich |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.......................................................................
& : member of the same patent family, corresponding document

EPO FORM 1503 03.82 (P04C01)

# EP 4 361 659 A1

Europäisches Patentamt
European Patent Office
Office européen des brevets

## EUROPEAN SEARCH REPORT

Application Number

EP 22 20 3550

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BASTY NICOLAS ET AL: "Reconstruction of 3D Cardiac MR Images from 2D Slices Using Directional Total Variation", 9 September 2017 (2017-09-09), SAT 2015 18TH INTERNATIONAL CONFERENCE, AUSTIN, TX, USA, SEPTEMBER 24-27, 2015; [LECTURE NOTES IN COMPUTER SCIENCE; LECT.NOTES COMPUTER], SPRINGER, BERLIN, HEIDELBERG, PAGE(S) 127 - 135, XP047439827, ISBN: 978-3-540-74549-5 [retrieved on 2017-09-09] * Sections 1, 2 * | 1,2,5-15 | |
| X | AMEROM JOSHUA F.P. ET AL: "Fetal whole-heart 4D imaging using motion-corrected multi-planar real-time MRI", MAGNETIC RESONANCE IN MEDICINE, 12 May 2019 (2019-05-12), XP93037418, US ISSN: 0740-3194, DOI: 10.1002/mrm.27798 * Section 2 * | 1-15 | |

TECHNICAL FIELDS SEARCHED (IPC)

The present search report has been drawn up for all claims

| Place of search | Date of completion of the search | Examiner |
|---|---|---|
| Munich | 5 April 2023 | Streif, Jörg Ulrich |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

24